Europäisches Patentamt

European Patent Office

Office européen des brevets

(19)

(11) Publication number: 0 394 015
A2

## EUROPEAN PATENT APPLICATION

(12)

(21) Application number: 90304156.4

(22) Date of filing: 18.04.90

(51) Int. Cl.5: C04B 35/00, C01G 3/00,
C01G 1/00

(30) Priority: 19.04.89 NZ 228820

(43) Date of publication of application:
24.10.90 Bulletin 90/43

(84) Designated Contracting States:
CH DE FR GB LI NL SE

(71) Applicant: HER MAJESTY THE QUEEN IN
RIGHT OF NEW ZEALAND
Department of Scientific and Industrial
Research Physics and Engineering
Laboratory Gracefield Road
Lower Hutt(NZ)

(72) Inventor: Tallon, Jeffery Lewis
3 Marine Drive, York Bay
Eastbourne(NZ)
Inventor: Pooke, Donald Mark
19 Matai Street
Lower Hutt(NZ)
Inventor: Presland, Murray Robert
4/1 Mahina Bay Road
Mahina Bay, Eastbourne(NZ)

(74) Representative: Perry, Robert Edward et al
GILL JENNINGS & EVERY 53-64 Chancery
Lane
London WC2A 1HN(GB)

(54) Methods for producing high temperature superconducting materials.

(57) A method of preparing a binary, ternary or higher metal oxide material containing copper and as one or more cations Y and/or any lanthanide rare earth element and capable of displaying superconductivity above 77K, comprising preparing said material such that said Y or lanthanide rare earth cation(s) is/are partially substituted by a substituent cation or cations which exhibit chemical valency lower than that of the substituted cation, to an amount of the substituent(s) effective to achieve a rate of oxygen diffusion or rate of oxygen exchange within an oxygen-containing atmosphere sufficient to enable oxygen exchange or oxygen diffusion into or out of said material to achieve the oxygen stoichiometry in said material whereby the material exhibits said superconductivity above 77K in a reduced time relative to that required to produce the equivalent unsubstituted material of the same porosity exhibiting superconductivity at the same temperature by otherwise the same method, including carrying out said oxygen diffusion or exchange in said reduced time.

## METHODS FOR PRODUCING HIGH TEMPERATURE SUPERCONDUCTING MATERIALS

The invention relates to methods for preparing binary, ternary, quaternary or higher metal oxide materials containing copper and capable of displaying superconductivity above 77K having high or enhanced oxygen-ion mobility or diffusion, or, for a given density and material dimensions, having a high or enhanced rate of oxygen exchange or diffusion with an ambient oxygen containing atmosphere.

Our prior European patent application No. 88312277.2 entitled "Methods for Producing High Temperature Superconducting Materials" discloses methods of preparing high temperature superconducting metal oxide materials in which the materials are prepared such that one or more alkali earth cations in the material are substituted by an alkali metal element. The methods disclosed enable the preparation of high temperature superconducting materials in reduced preparation times and/or to high densities. The entire content and disclosure of that prior specification is incorporated herein by reference.

Binary, ternary, quaternary and higher metal oxide materials containing copper and which exhibit superconductivity or which may be prepared to exhibit superconductivity above a temperature of 77K are exemplified by $YBa_2Cu_3O_{7-\delta}$ (referred to as YBCO materials or specifically as Y-123), $Bi_{2+x}(Ca,Sr)_{n+1}Cu_nO_{2n+4+\delta}$ (referred to as BCSCO), $Tl_{1+n}(Ca,Ba)_{n+1}Cu_nO_{2n+3+\delta}$ (referred to as TCBCO), and $Tl_{2+n}(Ca,Sr)_{n+1}Cu_nO_{2n+4+\delta}$. Typically, as described in the aforementioned prior specification, these above materials may be prepared by solid state reaction of precursor materials in stoichiometric proportions, for example, such as $Y_2O_3$, $BaCO_3$ and $CuO$ for YBCO, such as $Bi_2O_3$, $CaCO_3$, $SrCO_3$ and $CuO$ for BCSCO, and such as $Tl_2O_3$, $CaO$, $BaO$ and $CuO$ for TCBCO, followed by oxygen loading or unloading as appropriate to achieve the optimum oxygen stoichiometry for superconductivity, as described by D W Murphy et al, Science 241, 922 (1988); Buckley et al, Physica C156, 629(1988); and Torardi et al Science 240, 631 (1988), for example. The YBCO compound $YBa_2Cu_4O_8$ (referred to as Y-124) or $RBa_2Cu_4O_8$ where R is an element of the rare earth lanthanides (referred to as R-124), may be prepared by solid state reaction of $Y_2O_2$ or $R_2O_3$, and $CuO$ in stoichiometric proportions in oxygen at one atmosphere at temperatures below 840°C as described in our simultaneously filed patent application entitled "RBCO 124 Superconducting Materials". This compound has a fixed oxygen content and does not require adjustment of oxygen stoichiometry, for example by separate annealing, after synthesis.

In order to achieve maximum strength and toughness for the materials, it is important that they are prepared to a density close to the theoretical density and ideally to a density greater than 98% of the theoretical density for the material. The implementation of many of these materials as superconductors is seriously thwarted by a number of difficulties including the tendency of material prepared to a high density to crack on cooling after reaction and sintering in preparation of the material, and the difficulty, on a practical time scale, of loading oxygen into the high density material to achieve the correct oxygen stoichiometry for optimised superconductivity. It is difficult to load oxygen into materials prepared to a high density because of the low diffusion rate. The self diffusion coefficient for oxygen in Y-123 has been measured to be $2.9 \times 10^{-11}$ cm$^2$/sec at a temperature of 800 K (see Tallon et al, Applied Physics Letters 52, 507 (1988)). Therefore for a 1 mm thick 100% dense sample, it would take as much as 500 days for oxygen equilibration to take place. Nonetheless, oxygen loading or unloading is essential to optimising the superconducting properties. For R-123 if $\delta > 0.6$ superconductivity does not occur. If $0.2 < \delta < 0.6$ the superconducting transition temperature $T_c$ is about 60 K and only for $\delta < 0.2$ does $T_c$ approach 90 K.

Techniques known before the invention of our first aforementioned prior application for preparation of R-123 high temperature superconductors having the requisite oxygen stoichiometry for superconductivity at 90 K involve at least one heating of precursor materials to react for periods of 6 to 15 hours at temperatures typically in the range 930°C to 970°C, followed by slow cooling in an oxygen containing atmosphere at an appropriate oxygen partial pressure, as referred to. Cooling for extended times in the range 4 to 15 hours is required for typical densities of 70 to 85%. The slow cooling allows oxygen to progressively load into the material causing $\delta$ to decrease preferably to close to zero. The rate at which oxygen loads depends, amongst other things, on the density (or porosity) and the material dimensions, the rate decreasing as the density or dimensions increases. A typical example in prior references required a 3 day anneal in oxygen at 400°C for a dense sample (>96%) of thickness 0.3 mm.

It has now surprisingly been found that the reduced preparation times achieved with the method of the invention of our first aforementioned prior patent application may also be achieved where Ca is substituted as a cation in the metal oxide materials. Ca will substitute to a significant extent or predominantly for Y or lanthanide rare earth cations in YBCO, but may also substitute to an extent for other alkali earths such as Ba. Li, Na, K, Rb, or Cs may also be substituted for Y or lanthanide rare earth cations in the material. In fact, any cation of chemical valency lower than that of the substituted cation which will substitute in the preparation reaction (as will be described) may be employed.

Thus, in broad terms the present invention may be said to comprise a method of preparing a binary, ternary or higher metal oxide material containing copper and as one or more cations Y and/or any lanthanide rare earth element and capable of displaying superconductivity above 77K, comprising preparing said material such that said Y or lanthanide rare earth cation is partially substituted by a substituent cation or cations which exhibit chemical valency lower than that of the substituted cation, to an amount of the substituent(s) effective to achieve a rate of oxygen diffusion or rate of oxygen exchange within an oxygen-containing atmosphere sufficient to enable oxygen exchange or oxygen diffusion into or out of said material to achieve the oxygen stoichiometry in said material whereby the material exhibits said superconductivity above 77K in a reduced time relative to that required to produce the equivalent unsubstituted material of the same porosity exhibiting superconductivity at the same temperature by otherwise the same method, including carrying out said oxygen diffusion or exchange in said reduced time.

Preferably said reduced time is less than one half the time required to produce the equivalent unsubstituted material.

Preferably the substituent cation is any of Ca, Li, Na, K, Rb or Cs.

Most preferably the substitute cation is Ca or Ca in combination with any of Li, Na, K, Rb or Cs.

Most preferred materials which are Ca or alkali metal substituted in the method of the invention are:
(approximate compositions given):

$RBa_2Cu_3O_{7-\delta}$     ... (1)

where: $-0.1 < \delta < 1.0$ and most preferably $-0.1 < \delta < 0.6$;

$RBa_2Cu_4O_{8-\delta}$     ... (2)

where: $0.2 < \delta < 0.1$

where in formulae (1) and (2):

R is Y, La, Nd, Sm, Eu, Gd, Ho, Er, Dy, Yb, Ca or any combination thereof;
Ba may be partially replaced by La, Ca, Sr, Li, Na, K, Rb, Cs or any combination thereof;
Cu is mainly Cu but may be partially replaced by Ag, W, Ni, Ga, Li, Tl or any combination thereof.

The foregoing formulae are given as examples rather than intended to be limiting. Derivatives of these materials are for example possible, where the atomic elements in the formulae are partially substituted by other elements.

The substituted metal oxide materials prepared by the method of the invention may be prepared specifically by solid state reaction, liquid flux reaction, or vapour phase deposition reaction techniques as described in our aforementioned prior application, for example.

Ca or the alkali metals substituted into the subject materials are suitably introduced in preparation in the form of their oxides, but the preparation of the materials of the invention by the above techniques is complicated by the high temperatures and the long reaction and sintering times which are typically required. The volatility of the oxides at such temperatures is sufficient for substantial loss of the alkali over the long reaction and processing times. Out-diffusion and evaporation of the alkali from the metal oxide or its precursor during preparation under elevated temperatures may be prevented or controlled by controlling the ambient atmosphere including controlling the oxygen partial pressure and the alkali oxide partial pressure; by controlling the ambient temperatures; by enclosing the metal oxide or its precursor(s) in a sealed container; by providing excess precursor alkali to allow for loss; or by controlling the chemical potential of the alkali atoms in the metal oxide by electrochemical means.

Preparation of the materials of the invention in accordance with the method of the invention may be carried out more rapidly if in preparation of the materials by solid state reaction of precursor materials any or all of the cations in the end material are introduced as precursors in the nitrate or hydroxide forms for rapid reaction of bulk material in the nitrate or hydroxide melt. In the preparation of Ca-substituted Y-124, for example, by solid state reaction, the precursor materials may be $Y_2O_2$, $Ba(NO_3)_2$, $Ca(NO_3)_2$, and CuO. Ca may alternatively be introduced as $Ca(OH)_2$ for example. Both the temperature and duration of the preparation reaction may be lowered by using nitrate or hydroxide precursors to introduce the cations. Melting of the nitrate and/or hydroxide precursors allows intimate atomic mixing prior to decomposition.

Preferably in the preparation of R-124 materials in particular the precursor materials are reacted and sintered at a temperature T and oxygen partial pressure $Po_2$ satisfying the equation
$T < 1220 - 180L + 21L^2$ where $L = \log_{10}Po_2$.

After preparation the materials may be sintered or (re-)ground to small particles and pressed to shape and sintered as desired to form the end material for use, as is known in the art for the preparation of unsubstituted materials, and/or annealed to relieve stresses and increase strength and toughness as is similarly known in the art for the unsubstituted materials.

The precursor materials may alternatively be stoichiometrically mixed as nitrates in aqueous or other suitable solution and sprayed as a mist which is passed through an oven, furnace, microwave heating zone or the like for rapid reaction of the discrete droplets. The droplets may then be collected by way of a cyclone, filter, electrostatic precipitator, or the like.

The substituted metal oxide materials after preparation may as necessary be loaded or unloaded with oxygen to achieve the optimum stoichiometry for superconductivity. As stated, for R-123 materials for example this generally requires oxygen loading into the materials and with known techniques this is generally carried out by slow cooling or annealing the materials from at least 650°C to lower than 450°C over 4 to 15 hours or more depending on sample density and dimensions. Alkali metal or Ca substituted R-123 materials formed in accordance with the invention will typically only require a matter of minutes or even seconds for oxygen loading to occur, compared to equivalent unsubstituted materials of comparable density. Oxygen loading or unloading may be carried out by heating to comparable temperatures as used in oxygen loading/unloading of the unsubstituted materials as described in the prior references, followed by cooling over a time sufficient to achieve the required oxygen stoichiometry, which will typically be up to one hundred times shorter. Most suitably, oxygen loading or unloading is carried out during cooling from the reaction temperatures immediately after the preparation reaction, where the materials are prepared by solid state reaction for example. Alternatively and/or additionally oxygen loading may be carried out during sintering or annealing in an oxygen containing atmosphere at an appropriate pressure or partial pressure of oxygen. Where the materials are prepared by spraying an aqueous solution of the precursor materials as a mist through a heated reaction zone, the reacted particles may be rapidly oxygen loaded or unloaded by a short anneal in an oxygen containing atmosphere while still airborne, or after collection.

The substituent cations incorporated into the atomic structure of materials formed in accordance with the invention may be any of Ca, Li, Na, K, Rb or Cs. Na and K are preferred substituents and Ca is particularly preferred. Ca may for a given degree of substitution give higher oxygen loading rates, and has other advantages including lower volatility of the alkali at typical temperatures of preparation, greater resistance to atmospheric and moisture corrosion, and better sintering for a given temperature and duration of sinter, offering higher densification.

Materials formed with the method of the invention may be prepared in the form of thin films, thick films, filiaments, tapes, bulk ceramics or single crystals, for example.

Ca substitution or alkali metal substitution for Y or lanthanide rare earth cations in R-123, R-124, and their substitutional derivatives or other metal oxide materials of the type described results in enhanced oxygen mobility or diffusion in the material. The materials may be loaded or unloaded with oxygen more rapidly as described and/or higher density versions of the materials may be prepared relative to the unsubstituted materials for similar if not reduced temperatures and durations of sintering. In addition, the superconducting orthorhombic structure is more readily achieved for R-123 prepared with the method of the invention and less oxygen may be required in the material for orthorhombic structure and superconducting behaviour, and the orthorhombic to tetragonal transition in RBCO where anisotropic thermal expansion is largest is displaced to a higher temperature where oxygen mobility is greater. Higher densities may be achieved.

Preferred examples of the substituted metal oxide materials are any of

$R_{1-x}Ba_{2-y}A_{x+y}Cu_3O_{7-\delta}$

and

$R_{1-x}Ba_{2-y}A_{x+y}Cu_4O_8$

wherein $0 < x,y < 0.5$, A is Ca or Ca in combination with Na or K; and

$R_{1-x}A_xBa_{2-y}La_yCu_3O_{7.\delta}$

and

wherein $0 < x,y < 1.0$.

The invention is further described with reference to the following examples which further illustrate the preparation of materials in accordance with the method of the invention. In the drawings which are referred to in the examples:

Fig. 1 shows a plot of the XRD traces for 0.2 Ca substituted into $YBa_2Cu_3O_{7-\delta}$ for nominal compositions corresponding to 50%, 60%, 70%, 80%, 90% and 100% respectively on the Y-site and the remainder on the Ba-site. Y denotes $Y_2BaCuO_5$ impurity lines and B denotes $BaCuO_2$ impurity lines.

Fig. 2 shows plots of the increase in mass as a function of time due to oxygen loading in $Y_{0.85}Ba_{1.95}Ca_{0.2}Cu_3O_{7-\delta}$ with a density of 94%. The transient temperature in the furnace is also shown. (a) On changing the temperature from 754°C to 695°C the sample loads as quickly as the furnace alters temperature. (b) On changing the temperature from 558°C to 543°C.

Fig. 3 shows the time elapsed for (e-1)/e i.e. 0.63 of the total oxygen loading to take place in 100% oxygen for the sample shown in Fig. 2 and also for other temperatures. The data is shown as a function of temperature.

Fig. 4 shows the XRD patterns for samples of nominal composition $YBa_{1.8}Na_{0.2}Cu_4O_8$, $YBa_{1.9}Na_{0.1}Cu_4O_8$ and $YBa_{1.8}K_{0.2}Cu_4O_8$ each of which predominantly exhibits the structure of $YBa_2Cu_4O_8$ (1-2-4). The only impurity peaks are marked with dots.

Fig. 5 shows a plot of the resistivity of $YBa_{1.8}Na_{0.2}Cu_4O_8$ as a function of temperature.

Fig. 6 shows the phase diagram for the YBCO system showing the stability boundary for 124 as a function of oxygen partial pressure $P_{O2}$. The dashed line shows the O-T transition in metastable 123 and the oblique sloping lines show contours of constant composition in metastable 123 with values of $\delta$ shown.

Fig. 7 shows a plot of of the XRD traces for 0.2 Na substituted into $YBa_2Cu_3O_{7-\delta}$ for nominal compositions corresponding to 100%, 75%, 50% and 25% respectively on the Ba-site and the remainder on the Y-site. Patterns for $Y_2BaCuO_5$ and $BaCuO_5$ are shown for comparison.

Fig. 8 shows a plot of the XRD traces for 0.2 K substituted into $YBa_2Cu_3O_{7-\delta}$ for nominal compositions corresponding to 100% and 50% respectively on the Ba-site and the remainder on the Y-site. Patterns for $Y_2BaCuO_5$ and $BaCuO_5$ are shown for comparison.

Example 1

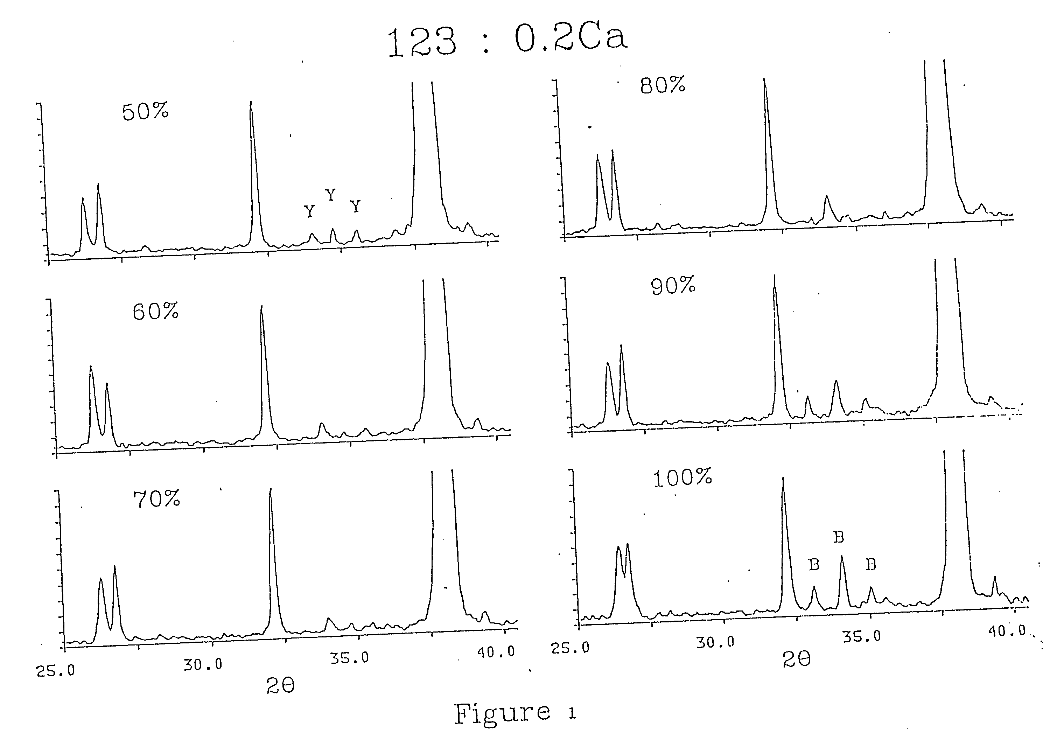

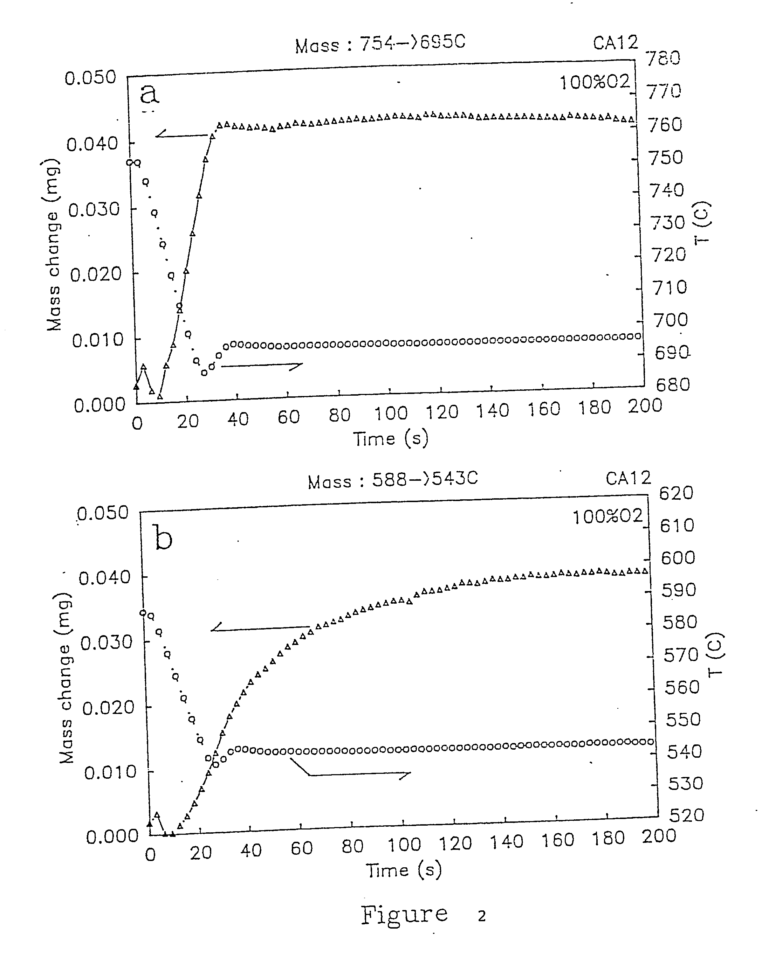

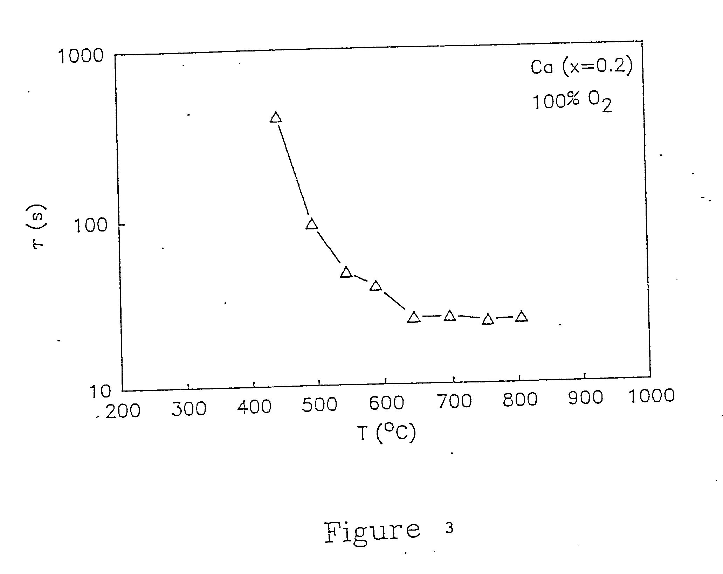

Examples of composition $Y_{1-x}Ba_{2-y}Ca_{x+y}Cu_3O_{7-\delta}$ were prepared by solid state reaction of stoichiometric quantities of $Y_2O_3$, $BaCO_3$, $CaCO_3$ and $CuO$. These were mixed, milled and reacted in air at 900°C for 12 hours. The result was ground and milled then sintered at 960°C. The resultant pellet had a density 98% of theoretical maximum density wherein similar treatment for unsubstituted material had hitherto resulted in densities of only 80 to 90%. Fig. 1 shows XRD patterns for these samples with $x + y = 0.2$ with, in sequence, $x(x'y) =$ 50, 60, 70, 80, 90 and 100%. Evidently Ca substitutes with about 75% on the Y-site and 25% on the Ba-site under the conditions of preparation. Fig. 2 shows the oxygen loading rate for a 0.2 Ca-substituted sample which was sintered at 930°C to obtain a density of 94% (6% porosity). At temperatures above 600°C the sample loads as quickly as the furnace changes temperature and the loading rate shown in Fig. 3 is much faster than for the unsubstituted material at a rather higher porosity of 13% (87% dense sample). For the same porosity of 6% the enhancement of oxygen loading rate is evidently in excess of 100 times. Examination of microstructure by scanning electron microscopy showed no difference in microstructure between the calcium-substituted and unsubstituted Y-123 and certainly no reduction in grain size which might account for the increase in oxygen loading rate.

Example 2

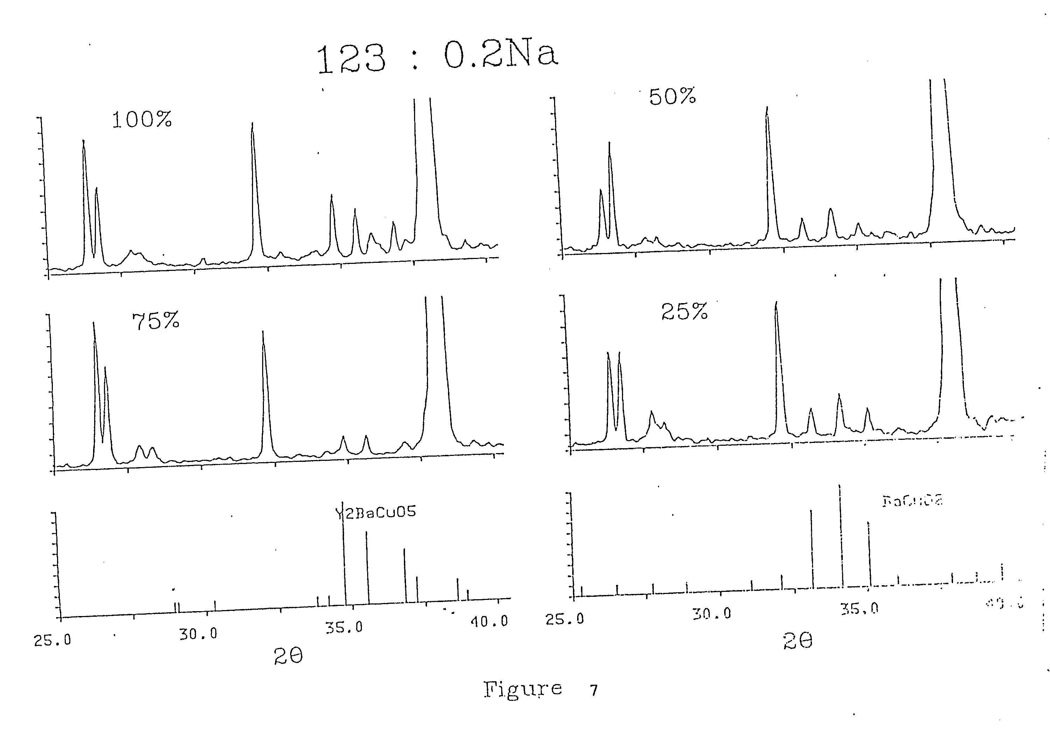

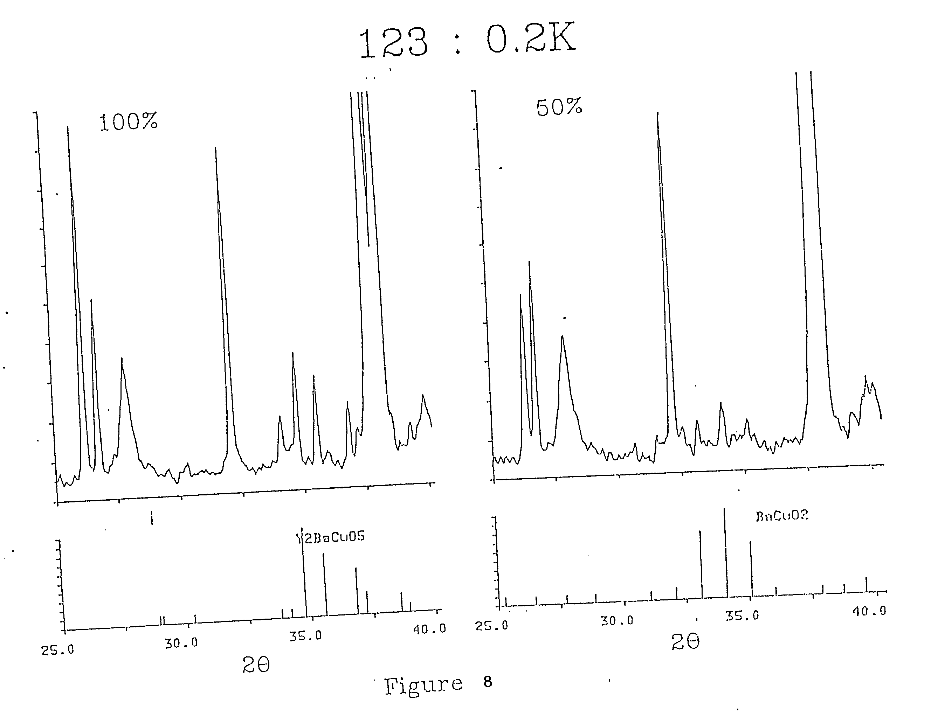

Synthesis were carried out to investigate possible distribution of substituted alkalis on both the Ba-site and the R- or Y-site. Samples of nominal composition $Y_{1-x}Ba_{2-s}K_{r+s}Cu_3O_{7-\delta}$ and $Y_{1-x}Ba_{2-s}Na_{r+s}Cu_3O_{7-\delta}$, were prepared by thorough mixing and prereacting as a powder bed in an alumina crucible at 700°C in order to ensure homogenous mixing in the nitrate melt before decomp·  ion and efflux of oxides of nitrogen. The residue  s transferred to a dry box for milling in an atmosphere of dry nitrogen. 10 and 13 mm diameter pellets were pressed in a die then reacted for 15 minutes to 930°C in a gold crucible with a close fitting lid in order to minimise egress of volatile alkali oxides. The pellets were reground and milled in an atmosphere of dry nitrogen, die-pressed as pellets and sintered for 15 minutes in the gold crucible. The short reaction and sintering times were to ensure minimal loss of alkali consistent with production of XRD phase-pure material. Fig. 7 shows CoK$\alpha$ x-ray diffraction (XRD) traces for these materials for attempted Na-substitution when (x,y) is (0,0.2) (0.05,0.15), (0.1,0.1) and (0.15,0.05). The first shows the presence of $Y_2BaCuO_5$ (211) phase, the second less of this phase, while the third and fourth show the progressive appearance of $BaCuO_2$. This indicates that the Na atoms are substituting somewhere between 25% and 50% on the Y-site and the remainder on the Ba-site. Fig. 8 shows XRD patterns for 0.2 K-substituted $YBa_2Cu_2O_{7-\delta}$ with (x,y) values of (0,0.2) and (0.1,0.1). The progressive shift from `excess $Y_2BaCuO_5$ to excess $BaCuO_2$ indicates 60 to 70% substitution on the Ba-site and 40 to 30% substitution on the Y-site.

Example 3

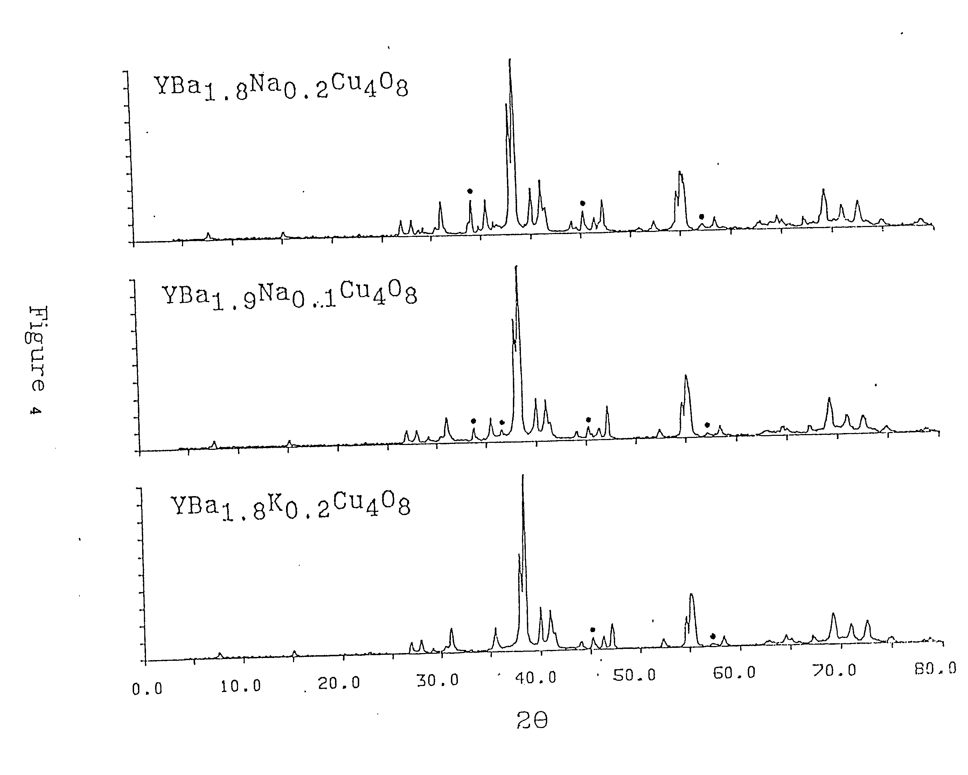

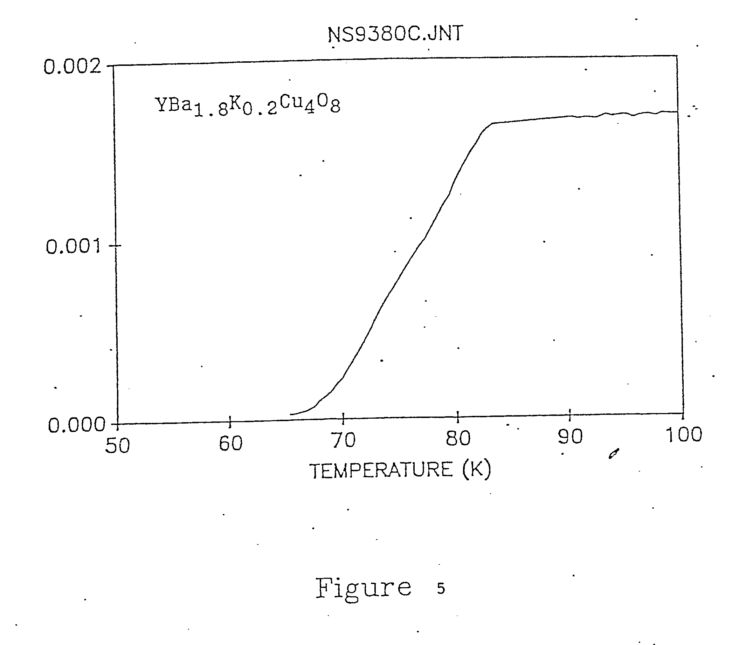

Samples of $YBa_2Cu_4O_{8-\delta}$ (referred to as Y-124) have hitherto been prepared as thin films and only by the application of very high oxygen pressure, as ceramics (Karpinsky et al Nature 336, 660(1989)). We have been able to prepare samples of nominal composition $Y_{0.8}Na_{0.2}Ca_2Cu_4O_8$, $YNa_{1.8}Na_{0.2}Cu_4O_8$, $YBa_{1.9}Na_{0.1}Cu_4O_8$ and $YBa_{1.8}K_{0.2}Cu_4O_8$ each of which predominantly exhibits the structure of $YBa_2Cu_4O_8$ (1-2-4) as shown by XRD. We also investigated a composition corresponding to $YBa_2Cu_4O_8 + 0.1Na_2O$. Powders of $Y_2O_3$, Ba-$(NO_3)_2$, $NaNO_3$ or $KNO_3$, and $CuO$ were weighed out in stoichiometric proportions, mixed, milled and reacted at 800°C or 12 to 24 hours. Even after 12 hours the 1-2-4 phase was present in proportions exceeding about 80%. Of these, the highest phase purity was obtained for the three samples designed for assumed substitution on the Ba-site i.e. the second, third and fourth of these examples. The XRD patterns are shown for these in Fig. 4 and the only impurity lines are those for unreacted CuO and $Y_2O_3$. The structure is A-centred orthorhombic and we obtain lattice parameters of $a = 3.842$ A, $B = 3.866$ A and $c = 27.239$ A. Fig. 5 shows the resistivity as a function of temperature for the second of these samples quenched into liquid nitrogen from different temperatures in air. The sample shows zero resistance at about 65K with resistive onset at about 82K as expected for Y-124. The breadth of the transition probably arises from the alkali substitution and possibly the presence of Y-123 intergrowths. The normal state resistance shows a small dependence on oxygen stoichiometry as determined by the annealing temperature. Attempts to grow the Y-124 phase under the same conditions but in the absence of the alkali showed no trace of the Y-124 phase. Similarly, attempts to grow the phase in air at 800°C or at 750°C using the same starting materials failed to produce any trace of the phase. Using Ca instead of Na under the same conditions of flowing oxygen at 800°C resulted in small quantities (10 to 15%) of Y-124. The facility with which the Y-124 phase is obtained may arise from increased oxygen mobility ensuring homogeneous, equilibrium oxygen potential throughout the body of the material at all times. This may be a crucial process as the oxygen stoichiometry of the Y-124 compound is more or less fixed at the value 8 per formula unit and the absence of vacancies in the chains will result in a very much lower oxygen diffusion coefficient than occurs in Y-123. At lower oxygen potential the Y-124 phase rapidly decomposes. We estimate the stability limit in air to be 780 to 790°C. The appearance of the Y-124 phase may also arise from the overall increase in atomic mobility for this compound when alkali-substituted or it could arise from the alkali oxide acting as a flux. We noted however that the alkali is present in oxide form at a level of only 1% and the XRD patterns for the variety of compositions investigated indicate atomic substitution rather than catalytic activity.

As stated, preparation of R-124 materials by the method of the invention may be optimised when the reaction and sintering are carried out at a temperature T and oxygen parital pressure $P_{O_2}$ which satisfy the equation

$T < 1220 - 180L + 21L^2$ where $L = \log_{10} P_{O_2}$.

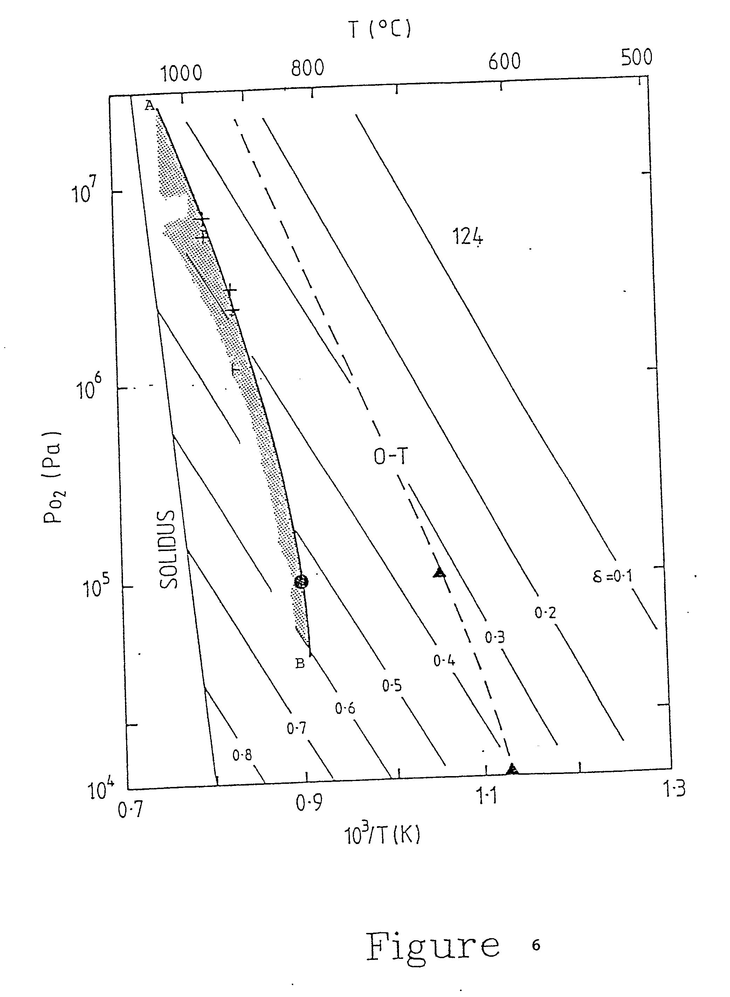

Referring to Fig. 6, this formula defines the region marked '124' to the right of the curve A-B which defines the 1-2-4 stability boundary. Most preferably reaction and sintering is carried out at a temperature and oxygen partial pressure as close to line A-B, of Fig. 6, as possible. It will be apparent that the substituted 1-2-4 materials may be prepared at ambient atmospheric pressures or near thereto. For example, $Y_{0.9}Ca_{0.1}Ba_2Cu_4O_8$ may be prepared in $10^5$ Pa of flowing oxygen below a temperature of 845°C though, in general, the exact location of this boundary will depend upon the composition and degree of elemental substitution. Because the reaction kinetics are slower in the lower temperature 1-2-4 region, reaction and sintering are preferably performed as close as is practical to the 124 stability boundary (i.e. line A-B in Fig. 6). For example, materials with composition $(Y/Ca)(Ba/Ca)_2Cu_4O_8$ and $(Er/Ca)(Ba/Ca)_2Cu_4O_8$ may be prepared in 1 bar of flowing oxygen at 838°C with and without $Na_2O$ or $K_2O$ as catalysts (as referred to below).

Material prepared at the lower temperature/lower pressure end of the 1-2-4 stability region will be porous and not ideally sintered, but, it may be densified by raising the temperature such that T is greater than that defined by the formula $T = 1220 - 180L + 21L^2$ where $L = \log_{10} P_{O_2}$ (i.e. outside the 1-2-4 stability region) for short duration. The initial sintering rate is faster than the decomposition rate and densification occurs. The material should typically, for example, be further annealed within the 1-2-4 stability region subsequent to densification, and several densification cycles could, for example, be employed. For advanced densification either the temperature or duration of sinter will need to be so large that 1-2-4 will begin to decompose to 1-2-3, or other phases, together with excess copper oxide but on further extended annealing within the stability band 1-2-4 wil regrow especially if the precipitates of copper oxides, resulting from the decomposition, are controlled to be finely dispersed. The oxygen partial pressure may be controlled by gas pressure or, alternatively, by use of electrochemical means to control the oxygen activity in the substituted 1-2-4, across the entire stability region shown in Fig. 6, by placing an oxygen-ion electrolyte conductor such as Y-stabilised $ZrO_2$ in contact with the material and maintaining an appropriate voltage across the cell thus formed according to the known methods of solid-state electrolyte cells, for example.

The reaction rate may be enhanced by the use of certain alkali metal fluxes, catalysts, or reaction rate enhancers which may operate by providing a molten or vapour flux or by temporary or permanent substitution into the lattice of the reactants or the final product. Such fluxes, catalysts or reaction rate enhancers for the preparation of substituted 1-2-4 materials comprise: the oxides, nitrates, carbonates, halides and hydroxides of the alkali metals. For example, in the preparation of Ca-substituted 1-2-4 the Ca is introduced in the precursor materials and an alkali metal catalyst such as the oxides of Na and K, which are preferred, may also be introduced in the precursor materials as $NaNO_3$ or $KNO_3$ which will decompose to their respective oxides. The attractive feature of these catalysts is that they are volatile and will, with time, evaporate off leaving phase-pure Ca-substituted 1-2-4. Further catalyst may be added as required at intermediate grinding and milling steps. The alkali metal may also be introduced, where the end material is to be Na or K substituted 1-2-4 for example, and the reaction carried out at reduced temperatures in a sealed reaction vessel to minimise volatilization of the alkali. It is preferable to employ small amounts only of alkali catalyst, preferably the oxides of Na or K in the preparation of Ca substituted 1-2-4, which are present during synthesis and which evaporate away during synthesis leaving sintered ceramic product. The mole fraction of introduced flux, catalyst or reaction rate enhancers may be less than 1.0 and is preferably in the range 0.1 to 0.2. This enables the synthesis of ceramic product, as opposed to powder.

The foregoing describes the invention including preferred forms and examples thereof. The preparation of alkali-substituted materials other than those specifically exemplified will be within the scope of those skilled in the art in view of the foregoing. The scope of the invention is defined in the following claims.

## Claims

1. A method of preparing a binary, ternary or higher metal oxide material containing copper and as one or more cations Y and/or any lanthanide rare earth element and capable of displaying superconductivity above 77K, comprising preparing said material such that said Y or lanthanide rare earth cation(s) is/are partially substituted by a substituent cation or cations which exhibit chemical valency lower than that of the substituted cation, to an amount of the substituent(s) effective to achieve a rate of oxygen diffusion or rate of oxygen exchange within an oxygen-containing atmosphere sufficient to enable oxygen exchange or oxygen diffusion into or out of said material to achieve the oxygen stoichiometry in said material whereby the material exhibits said superconductivity above 77K in a reduced time relative to that required to produce the equivalent unsubstituted material of the same porosity exhibiting superconductivity at the same temperature by otherwise the same method, including carrying out said oxygen diffusion or exchange in said reduced time.

2. The method of claim 1, wherein said reduced time is less than one half the time required to produce the equivalent unsubstituted material.

3. The method of either one of claims 1 and 2, wherein the substituent cation is any of Ca, Li, Na, K, Rb or Cs.

4. The method of either one of claims 1 and 2, wherein the substituent cation is Ca or Ca in combination with any of Li, Na, K, Rb or Cs.

5. The method of either one of claim 1 and 2, wherein the substituent cation is Ca.

6. The method of any one of claims 1 to 5, wherein the said metal oxide material into which cations are substituted has the approximate composition
$RBa_2Cu_3O_{7-\delta}$
where: $-0.1 < \delta < 1.0$;
R is Y, La, Nd, Sm, Eu, Gd, Ho, Er, Dy, Yb, Ca or any combination thereof;
Ba may be partially replaced by La, Ca, Sr, Li, Na, K, Rb or Cs, or any combination thereof;
Cu is mainly Cu but may be partially repaced by Ag, W, Ni, Ga, Li, Tl or any combination thereof; and
O may be partially repaced by F.

7. The method of claim 6, wherein the material is prepared such that $-0.1 < \delta < 0.6$.

8. The method of claim 6, wherein the material is prepared such that $-0.1 < \delta < 0.2$.

9. The method of any one of claims 1 to 5, wherein the said metal oxide material into which cations are substituted has the following approximate composition
$RBa_2Cu_4O_{8-\delta}$
where: $-0.2 < \delta < 0.1$;
R is Y, La, Nd, Sm, Eu, Gd, Ho, Er, Dy, Yb, Ca or any combination thereof;
Ba may be partially replaced by La, Ca, Sr, Li, Na, K, Rb, or Cs or any combination thereof;
Cu is mainly Cu but may be partially replaced by Ag, W, Ni, Ga, Li, Tl or any combination thereof; and
O may be partially replaced by F.

10. The method of any one of claims 1 to 3, and 6 to 8, wherein the substituted metal oxide material is
$R_{1-x}Ba_{2-y}A_{x+y}Cu_3O_{7-\delta}$
wherein $0 < x,y < 1.0$ provided that $x+y \neq 0$, $-0.1 < \delta < 1.0$;
and A is any of, or any combination of Ca, Na, or K.

11. The method of any one of claims 1 to 3 and 9, wherein the substituted metal oxide material is
$R_{1-x}Ba_{2-y}A_{x+y}Cu_4O_8$
wherein $0 < x,y < 1.0$ provided that $x+y \neq 0$, and A is any of, or combination of Ca, Na or K.

12. The method of either of claims 10 or 11, wherein A is Ca.

13. The method of any one of claims 1 to 12, wherein the said substituted metal oxide material is prepared by solid-state-, liquid-flux-, vapour-transport- or plasma-reaction of precursor materials in stoichiometric proportions.

14. The method of any one of claims 1 to 12, wherein the said substituted metal oxide material is prepared by reaction and sintering.

15. The method of any one of claims 1 to 8, 10, 13 and 14, wherein said oxygen exchange is carried out by annealing.

16. The method of any one of the preceding claims, wherein the material is prepared by solid-state- or liquid-flux-reaction of precursor materials in stoichiometric proportions contained in a sealed vessel, optionally charged with excess alkali precursor, to reduce evaporation of the alkali oxide during synthesis and sintering.

17. The method of claim 16, wherein after said reaction the material is then cooled and said oxygen exchange is carried out by annealing in an oxygen-containing atmosphere to lower than 450°C.

18. The method of any one of claims 1 to 12, wherein the material is prepared by mixing the precursor materials in aqueous solution, and then spraying said solution as a mist through a heated reaction zone for rapid reaction of the discrete droplets.

19. The method of claim 18 including carrying out said oxygen exchange by annealing the reacted particles in an oxygen-containing atmosphere while still airborne.

20. The method of any one of the preceding claims, wherein the material is prepared to greater than 96% of theoretical density.

Figure 1

Figure 2

Figure 3

Figure 4

Figure 5

Figure 6

123 : 0.2Na

Figure 7

123 : 0.2K

100%

50%

Figure 8